# EUROPEAN PATENT APPLICATION

(11) **EP 3 740 047 A1**
(43) Date of publication of application: **18.11.2020**
(21) Application number: 18900496.3
(22) Date of filing: 18.12.2018
(51) Int. Cl.: H05K 1/03, H05K 3/00

(54) **CERAMIC CIRCUIT BOARD**

(30) Priority: 12.01.2018 KR 20180004641
(71) Applicant: KCC Corporation, Seoul 06608 (KR)
(72) Inventor: KWAK, Man Suk, Seoul 04129 (KR); KIM, Bo Kyeong, Jeonju-si, Jeollabuk-do 54821 (KR); KIM, Kyong Hwan, Wanju-Gun, Jeollabuk-do 55316 (KR)
(74) Representative: Cabinet Laurent & Charras
(86) International application number: PCT/KR2018/016114
(87) International publication number: WO 2019/139266

(57) **Abstract**

A ceramic substrate included in a ceramic circuit board of the present invention comprises a cutout portion having multiple recessed cutout grooves arranged thereon and provided between circuit patterns, and thus can minimize both the occurrence of defective cutting of the ceramic circuit board in a cutting process and the occurrence of a crack on the ceramic substrate after an ultrasonic welding process.

## Description

### [Technical Field]

The present disclosure relates to a ceramic circuit substrate.

### [Background Art]

A ceramic circuit substrate (what is called a metal-bonded ceramic substrate) in which metal such as copper (Cu) or aluminum (Al) is bonded to a substrate formed of a ceramic material such as alumina (Al₂O₃), aluminum nitride (AlN), silicon carbide (SiC), or silicon nitride (Si₃N₄) has been widely used in a power module for a power semiconductor.

A direct copper bonding (DCB) method of directly bonding a copper plate to a substrate by bringing metal such as copper into contact with a ceramic substrate and thereafter heating the copper to a temperature lower than the melting point (1083°C) of copper and higher than the eutectic point (1065°C) of copper and oxygen has been developed and commercialized as a method of integrally bonding a ceramic substrate and a metal circuit plate. Recently, a ceramic circuit substrate manufactured by an active metal brazing method of bonding a metal circuit substrate through a brazing material layer for the purpose of radiating a larger amount of heat and maintaining strong mechanical bonding properties has been developed and applied to a power semiconductor that requires high reliability.

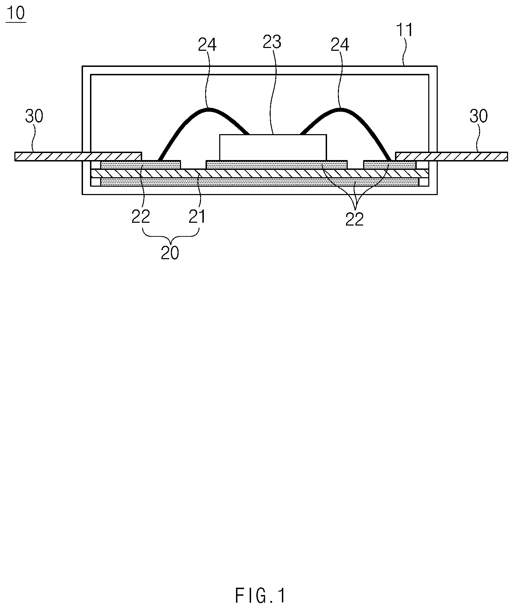

FIG. 1 is a schematic view illustrating a power module 10 including a ceramic circuit substrate manufactured by the above-described method.

In general, the power module 10 has a structure in which a semiconductor chip 23 is mounted on a ceramic circuit substrate 20 having a ceramic base plate 21 and a metal circuit plate 22 bonded with each other, internal components are connected by wires 24, and a case 11 covers and protects a circuit of the substrate. The circuit is connected with an external device by lead frames 30 and operates by receiving an electrical signal and power. The lead frames 30 are bonded to the metal circuit plate 22 of the ceramic substrate 20 by an adhesive such as silver solder or the like.

However, the method of bonding the lead frames 30 in the related art is vulnerable to vibration or a solder crack and has to use an environmental pollutant such as lead, harmful gas, or the like.

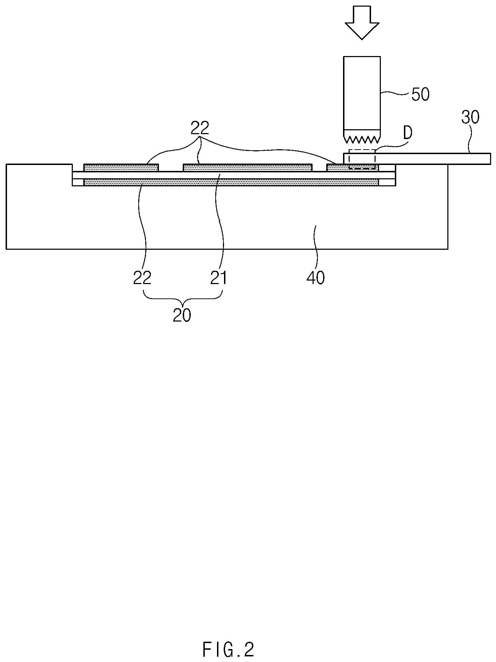

Recently, an ultrasonic welding method has been used to address the aforementioned drawbacks. FIG. 2 is a schematic view illustrating an ultrasonic welding method. The ultrasonic welding method is a method of bonding a lead frame 30 to a metal circuit plate 22 by fixing a ceramic circuit substrate 20 to a fixing jig 40 and applying pressure to the lead frame 30 by ultrasonic vibration of an ultrasonic oscillator 50 to instantaneously melt the lead frame 30.

However, when the ultrasonic welding is performed, there may be cracks in the substrate due to the pressure applied to fix the ceramic circuit substrate 20 and the vibration by ultrasonic waves applied to the ceramic circuit substrate 20. When the substrate has cracks in it, the power module 10 cannot normally operate due to current leakage on the back and bottom surfaces of a circuit pattern.

Accordingly, a ceramic circuit substrate having no cracks caused by an external force even when the external force such as ultrasonic welding is applied to the ceramic circuit substrate after the ceramic circuit substrate is manufactured is required.

### [Disclosure]

### [Technical Problem]

An aspect of the present disclosure provides a ceramic circuit substrate for minimizing a crack defect when a lead frame is welded by ultrasonic welding while minimizing a cutting defect in a cutting process of dividing the ceramic circuit substrate into separate circuit substrates by improving the shape of cutting recesses of a cutting portion.

Another aspect of the present disclosure provides a ceramic circuit substrate for improving product reliability while reducing power-module manufacturing costs.

### [Technical Solution]

According to an aspect of the present disclosure, a ceramic circuit substrate includes a ceramic substrate and a metal layer that forms circuit patterns on a surface of the ceramic substrate, and the ceramic substrate includes a cutting portion in which a plurality of cutting recesses provided between the circuit patterns and concavely formed on the ceramic substrate are arranged.

The cutting recesses may be formed to minimize a cutting defect when the ceramic circuit substrate is cut along the cutting portion and minimize cracks in the ceramic substrate and the metal layer by distributing stress when an external force is applied after the cutting.

### [Advantageous Effects]

As described above, the ceramic circuit substrate according to the embodiment of the present disclosure may minimize a crack defect when a lead frame is welded by ultrasonic welding while minimizing a cutting defect in a cutting process of dividing the ceramic circuit substrate into separate circuit substrates by improving the shape of the cutting recesses of the cutting portion.

Accordingly, according to the present disclosure, the ceramic circuit substrate may provide an effect of improving product reliability while reducing power-module manufacturing costs.

### [Description of Drawings]

FIG. 1 is a schematic view illustrating a power module including a ceramic circuit substrate in the related art.
FIG. 2 is a schematic view illustrating an ultrasonic welding method in the related art.
FIG. 3 is a plan view illustrating a ceramic circuit substrate according to the present disclosure.
FIG. 4 is a view illustrating a separate circuit substrate obtained by cutting the ceramic circuit substrate of FIG. 3 depending on predetermined unit circuit patterns.
FIG. 5 is a photograph obtained by analyzing portion B of FIG. 4 through a scanning acoustic microscope (SAM).
FIG. 6 is a photograph of a section of a cutting portion taken along line A-A of FIG. 3.
FIG. 7 is an enlarged photograph of portion E of a side surface of the ceramic circuit substrate illustrated in FIG. 6.
FIG. 8 is a schematic sectional view illustrating cutting recesses of the cutting portion according to the present disclosure.
FIG. 9 is a graph depicting a crack defect incidence rate depending on the angle between a first inclined surface and a second inclined surface.
FIG. 10 is an enlarged sectional view illustrating a state in which a curved surface is formed on a corner of a cutting recess of the present disclosure.

### [Mode for Invention]

Hereinafter, exemplary embodiments of the present disclosure will be described in detail with reference to the accompanying drawings.

The embodiments to be described below are embodiments appropriate for the understanding of technical features of a ceramic circuit substrate according to the present disclosure. However, the present disclosure is not limited to the embodiments to be described below, and technical features of the present disclosure are not restricted by the embodiments. Furthermore, various changes and modifications can be made without departing from the spirit and scope of the present disclosure.

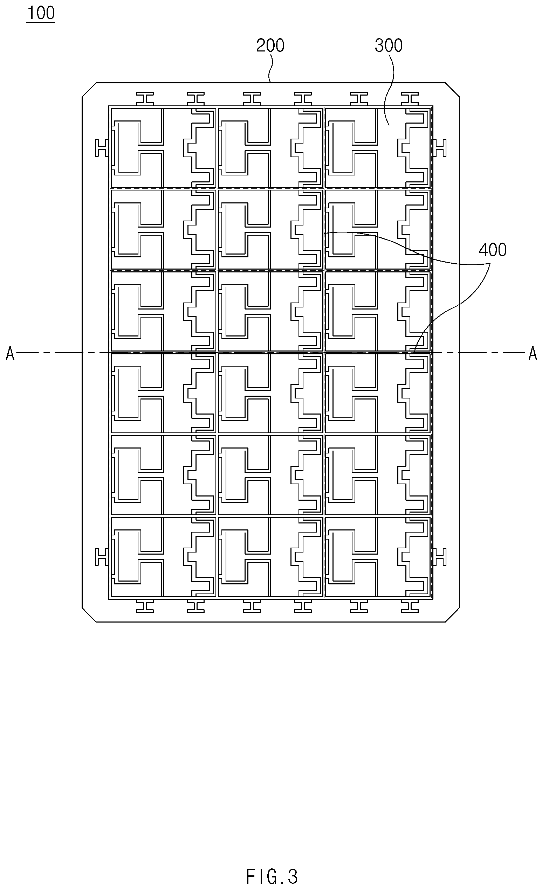

Referring to FIGS. 3, 4, and 6, a ceramic circuit substrate 100 of the present disclosure includes a ceramic substrate 200 and a metal layer 300, and the ceramic substrate 200 includes cutting portions 400.

The ceramic substrate 200 may be formed in a plate shape. Specifically, the ceramic substrate 200 may be formed of a ceramic material such as alumina (Al₂O₃), aluminum nitride (AlN), silicon carbide (SiC), or silicon nitride (Si₃N₄).

The metal layer 300 is boned to a surface of the ceramic substrate 200 and forms predetermined unit circuit patterns repeatedly disposed on the surface of the ceramic substrate 200 in the longitudinal or lateral direction.

Specifically, the metal layer 300 for forming the circuit patterns on the ceramic substrate 200 may be bonded to an upper surface or a lower surface of the ceramic substrate 200, or may be boned to both the upper surface and the lower surface of the ceramic substrate 200 as illustrated. The metal layer 300 may be formed over the entire ceramic substrate 200, and at this time, the predetermined unit circuit patterns may be repeatedly disposed on the surface of the ceramic substrate 200 in the longitudinal or lateral direction.

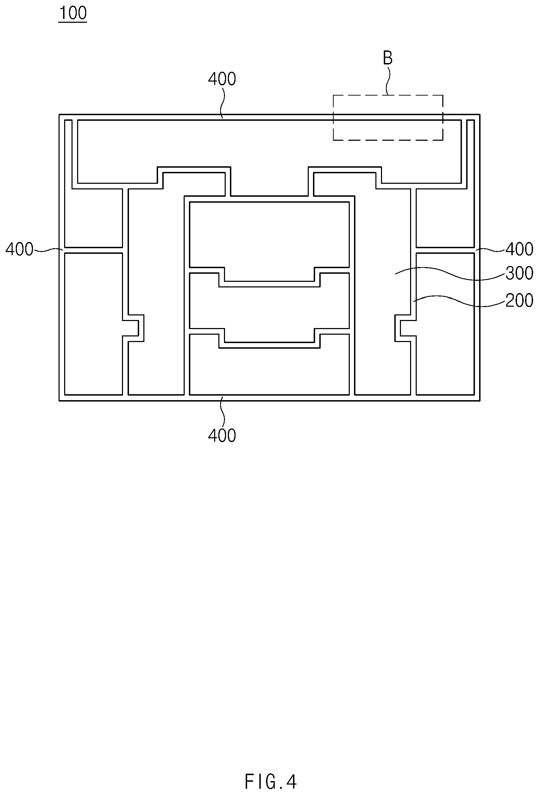

FIG. 3 is a view illustrating the ceramic circuit substrate 100 having the predetermined unit circuit patterns simultaneously formed on the one ceramic substrate 200, and FIG. 4 is a view illustrating a separate circuit substrate obtained by cutting the ceramic circuit substrate 100 of FIG. 3 depending on the predetermined unit circuit patterns.

Here, the predetermined unit circuit patterns may be separate unit circuit patterns required for separate circuit substrates used in semiconductor power modules. Desired circuit patterns of the separate circuit substrates may be simultaneously formed on the one ceramic substrate 200 in the longitudinal or lateral direction, and thereafter the ceramic substrate 200 may be divided into the separate circuit substrates for use. That is, the plurality of circuit substrates may be simultaneously manufactured on the one ceramic circuit substrate 100.

The sizes of separate circuit substrates required by manufacturers of power modules may vary depending on application fields. Accordingly, to reduce manufacturing costs and improve production efficiency, a substrate manufacturer simultaneously manufactures a plurality of circuit substrates on one ceramic circuit substrate 100.

The ceramic circuit substrate 100 of the present disclosure, which has the plurality of circuit patterns simultaneously formed on the ceramic substrate 200, may be divided into the separate circuit substrates for use in semiconductor power modules by cutting the ceramic circuit substrate 100 through the cutting portions 400 formed on the ceramic substrate 200.

Each of the cutting portions 400 for dividing the ceramic substrate 200 depending on the predetermined unit circuit patterns includes a plurality of cutting recesses 410 provided between the predetermined unit circuit patterns and concavely formed on the ceramic substrate 200.

Specifically, the cutting portion 400 is provided between the metal layers 300 and includes the cutting recesses 410 formed on the surface of the ceramic substrate 200. The cutting portion 400 may serve as a cutting line when the ceramic circuit substrate 100 is divided into the separate circuit substrates by cutting.

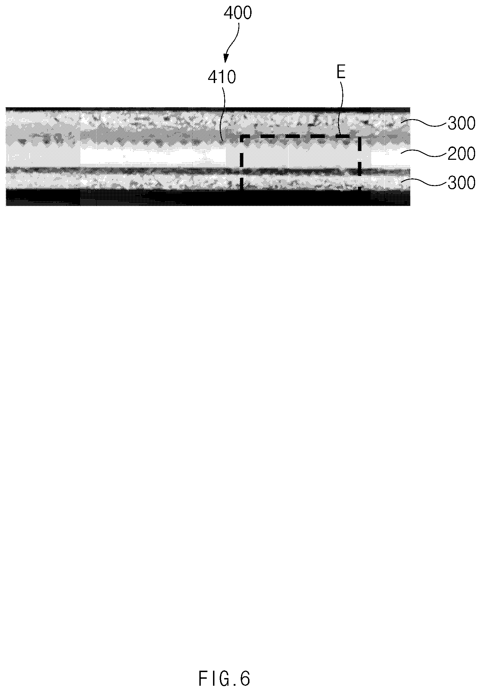

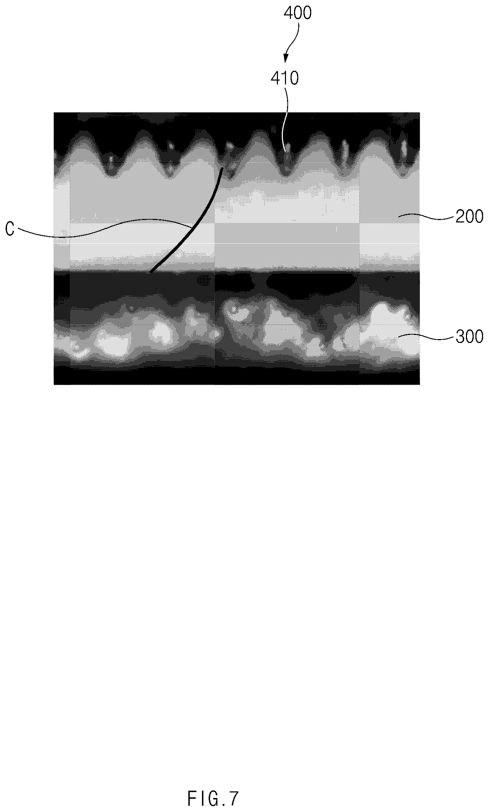

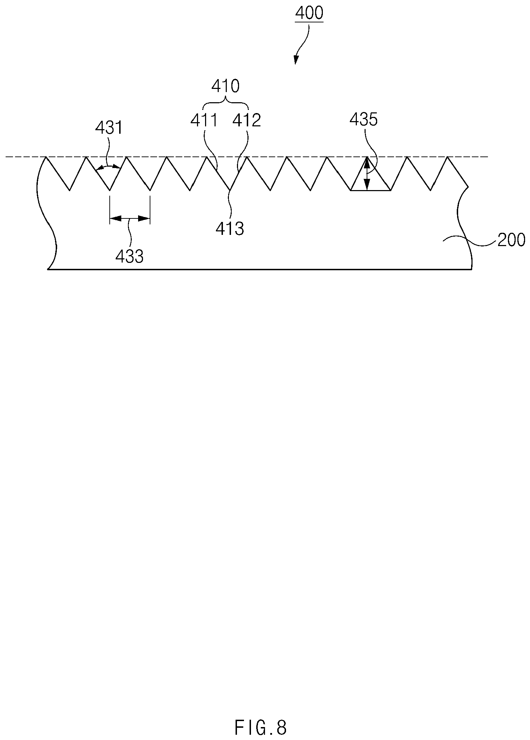

FIG. 6 is a photograph of a section of the cutting portion 400 taken along line A-A of FIG. 3. FIG. 7 is an enlarged view illustrating portion E of FIG. 6. FIG. 8 is a schematic sectional view illustrating the cutting recesses 410 of the cutting portion 400.

Referring to FIGS. 6 to 8, the cutting recesses 410 may be concavely formed on one surface of the ceramic substrate 200. Here, the cutting recesses 410 may be formed in advance in an illustrated shape on the ceramic substrate 200 by a pulsed laser and may allow the ceramic substrate 200 to be easily cut at a desired location. However, the shape of the cutting recesses 410 may be minutely changed due to a slight error in a process of being continuously machined by the laser.

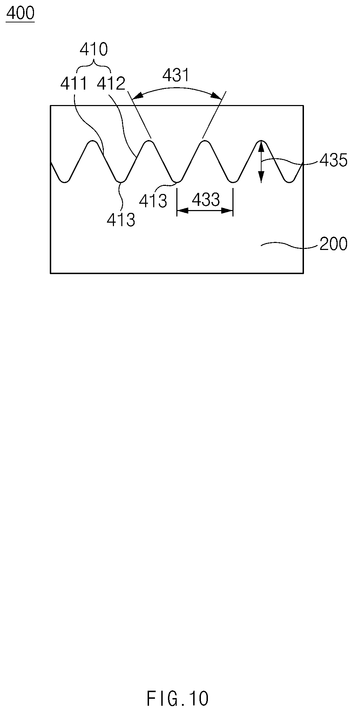

More specifically, as in the embodiment illustrated in FIG. 8, the cutting recesses 410 may include a first inclined surface 411, a second inclined surface 412, and a corner 413. The first inclined surface 411 may be a surface inclined at a predetermined angle 431 with respect to a virtual line perpendicular to the ceramic circuit substrate 100, the second inclined surface 412 may be formed to be symmetric to the first inclined surface 411 with respect to the virtual line, and the corner 413 may be a portion where the first inclined surface 411 and the second inclined surface 412 meet. As described above, the cutting recesses 410 may be formed in the shape of "V" that includes the first inclined surface 411, the second inclined surface 412, and the corner 413. Here, the corners 413 of the cutting recesses 410 are not limited to the pointed shape illustrated in FIG. 8 and may have a curved shape (refer to FIG. 10), or may have a flat surface (not illustrated).

The shape of the cutting recesses 410 may be formed to minimize a cutting defect when the ceramic substrate 200 is cut along the cutting portion 400 and minimize a crack in the ceramic substrate 200 and the metal layers 300 by distributing stress when an external force is applied after the cutting.

Here, the cutting defect means that the ceramic circuit substrate 100 is cut in a different direction rather than a desired direction, or chips are generated on a cut section, in a process of dividing the ceramic circuit substrate 100 depending on the predetermined unit circuit patterns. The crack defect means that a crack in ceramic is observed through a SAM or an X-ray after an ultrasonic welding process of bonding a lead frame to a separate circuit substrate after the cutting process.

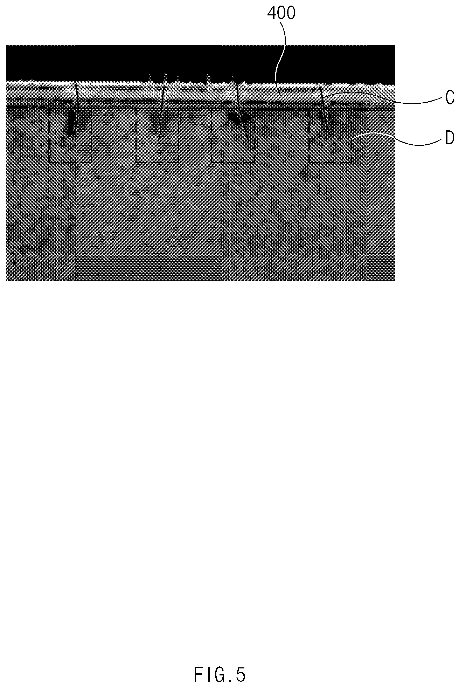

FIG. 4 is a view illustrating a separate circuit substrate, and FIG. 5 is a photograph obtained by analyzing portion B of FIG. 4 through a scanning acoustic microscope (SAM). Portion D of FIG. 5 is a position to which a lead frame is bonded by ultrasonic welding, and line C corresponds to a crack in a ceramic substrate of the separate circuit substrate. Furthermore, FIG. 7 is an enlarged photograph of portion E of a side surface of the ceramic substrate illustrated in FIG. 6, and line C of FIG. 7 corresponds to a crack in the ceramic substrate.

By analyzing the bonded position of the lead frame with a scanning acoustic microscope (SAM), a defect in the separate circuit substrate (cutting quality or a crack) may be identified after the ceramic circuit substrate is cut and the lead frame is welded to the separate circuit substrate by ultrasonic welding (refer to FIG. 2).

A crack in the ceramic substrate starts from a small coupling portion having a micro-meter size and leads to fracture after propagated. Referring to FIG. 5, it can be seen that the crack is propagated by about 5 mm to 8 mm in a direction from an end of the ceramic substrate to the center thereof. Furthermore, referring to FIG. 7, it can be seen that the crack starts from the cutting recess 410 formed on the ceramic substrate for cutting.

Stress is concentrated on the ceramic substrate 200 of the ceramic circuit substrate 100 by vibration of an oscillator that is applied for ultrasonic welding, and the crack starts from the cutting recess 410, which is the weakest portion, and is propagated to the central portion of the separate ceramic substrate 200. Accordingly, occurrence of a crack may be minimized by improving the shape of the cutting recess 410.

Specifically, the cutting recess 410 may have an angle of 71 degrees or more between the first inclined surface 411 and the second inclined surface 412. When the angle between the first inclined surface 411 and the second inclined surface 412 is smaller than 71 degrees, stress may be concentrated on the cutting recess 410, particularly, the corner 413 during ultrasonic welding, and a crack is more likely to occur. In contrast, when the angle between the first inclined surface 411 and the second inclined surface 412 increases to 71 degrees or more, during ultrasonic welding, stress concentration on the corner 413 by vibration may be alleviated, and a crack is less likely to occur.

As the angle between the first inclined surface 411 and the second inclined surface 412 of the cutting recess 410 increases, the depth of the cutting recess 410 may be decreased, or the interval between the corners 413 of the cutting recesses 410 adjacent to each other is increased. Accordingly, the angle between the first inclined surface 411 and the second inclined surface 412 of the cutting recess 410 may be appropriately adjusted depending on the interval between the corners 413 of the cutting recesses 410 and the depth of the cutting recesses 410, and in the present disclosure, the angle between the first inclined surface 411 and the second inclined surface 412 of the cutting recess 410 may range from 71 degrees to 77 degrees. When the angle exceeds 77 degrees, the depth of the cutting recess 411 depending on laser machining may not be ensured.

Furthermore, the interval between the corners 413 of the cutting recesses 410 adjacent to each other may range from 120 µm to 140 µm. When the interval between the corners 413 of the cutting recesses 410 adjacent to each other is less than 120 µm, a chip may be generated on a cut section, and when the interval between the corners 413 of the cutting recesses 410 adjacent to each other exceeds 140 µm, the ceramic circuit substrate 100 may be cut in a different direction rather than a desired direction due to the wide interval between the cutting recesses 410.

Accordingly, the interval between the corners 413 of the cutting recesses 410 adjacent to each other may range from 120 µm to 140 µm, and thus a cutting defect may be minimized when the ceramic circuit substrate 100 is divided depending on the predetermined unit circuit patterns.

Meanwhile, the cutting recess 410 may be formed to have a depth of 30% to 54% of the thickness of the ceramic substrate 200. When the depth of the cutting recess 410 is less than 30% of the thickness of the ceramic substrate 200, a cutting defect may occur during cutting due to the small depth of the cutting recess 410, and when the depth of the cutting recess 410 exceeds 54% of the thickness of the ceramic substrate 200, a crack is likely to occur during ultrasonic welding due to the large depth of the cutting recess 410.

Accordingly, the cutting recess 410 may be formed to have a depth of 30% to 54% of the thickness of the ceramic substrate 200 to minimize a cutting defect and a crack defect.

Meanwhile, the corner 413 may be curvedly formed to have a radius of curvature of 20 µm to 50 µm. At this time, the curved surface or the curve at the center of the corner is considered as a circular arc, and the radius of curvature of the corner refers to the radius of the circular arc.

When the radius of curvature of the corner 413 is less than 20 µm, during ultrasonic welding, stress may be concentrated on the corner 413, and a crack may be more likely to occur. In contrast, when the radius of curvature of the corner 413 exceeds 50 µm, a laser machining defect may occur when the cutting recess 410 is formed.

The cutting recess 410 of the ceramic substrate may be continuously formed through notch machining using a laser, and at this time, the angle, interval, and depth of the cutting recess and the radius of curvature of the corner may be formed as listed in Tables 1 and 2. The angle of the cutting recess is an angle between an extension line of the first inclined surface 411 and an extension line of the second inclined surface 412, the interval is the distance between the lowest points of the corners 413 of the cutting recesses 410 adjacent to each other, and the depth is a length from an extending surface, which extends from the upper surface of the ceramic substrate, to the lowest point of the corner. Furthermore, the radius of curvature of the corner 413 is the radius of a circle of curvature that is drawn with the curved portion located at the center of the corner 413 as a circular arc.

Due to the continuous laser notch machining, an error may occur in the cutting recess 410 formed on the ceramic substrate. That is, in the embodiments and the comparative examples of Tables 1 and 2, the angles, the intervals, the depths, and the radii of curvature of corners may have an error of about ± 2°, an error of about ± 9 µm, an error of about ± 10 µm, and an error of about ± 3 µm, respectively. Accordingly, as the values in the embodiments and the comparative examples of Tables 1 and 2 have the errors, the values are average values for cutting recesses to be formed on specimens.

The separate circuit substrate is manufactured by forming the metal layer having the predetermined circuit pattern on the ceramic substrate having the cutting recess 410 formed through laser notch machining and thereafter cutting the ceramic substrate depending on unit circuit patterns. The manufactured separate circuit substrate is welded to a lead frame by ultrasonic welding, and an experiment is performed.

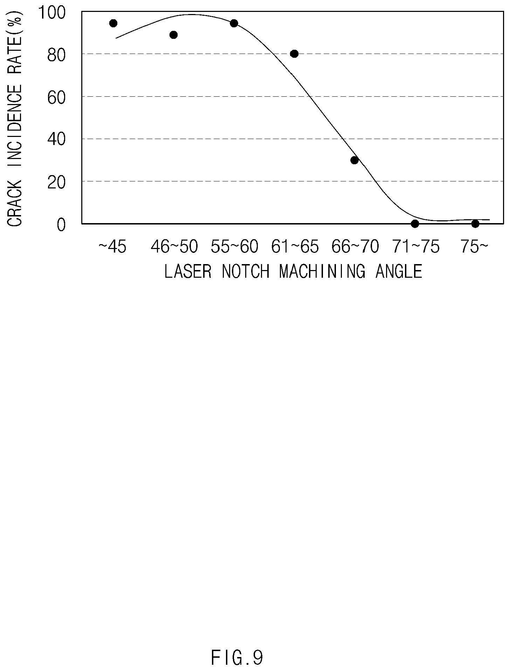

FIG. 9 is a graph depicting a crack incidence rate depending on a change in the angle 431 between the first inclined surface 411 and the second inclined surface 412. Furthermore, as in Tables 1 and 2 below, a cutting defect rate or a crack defect rate occurring in the ceramic substrate is measured depending on a change in the angle 431 of the cutting recess 410, the depth 435 of the cutting recess 410, the interval 433, and the radius of curvature of the corner 413.

The cutting defect rate represents a defect rate at which it is observed through a SAM or with naked eyes that when 20 specimens for each of the embodiments or the comparative examples are cut, desired portions are not cut, the specimens are not cut in a desired direction, or chips are generated on cut sections, and the crack defect rate represents a defect rate at which a crack is observed through a SAM or an X-ray after an ultrasonic welding process of bonding the 20 separate specimens to lead frames.

Furthermore, the angle is an angle between an extension line of the first inclined surface 411 and an extension line of the second inclined surface 412, the interval is the distance between the lowest points of the corners 413 of the cutting recesses 410 adjacent to each other, and the depth is a length from an extending surface, which extends from the upper surface of the ceramic substrate, to the lowest point of the corner. Moreover, the radius of curvature of the corner 413 is the radius of a circle of curvature that is drawn with the curved portion located at the center of the corner 413 as a circular arc.

For reference, the specimens used in the experiment are ceramic circuit substrates in which the ceramic substrate 200 has a thickness of 0.32 mm and the metal layer 300 has a thickness of 0.3 mm.

However, the experimental examples below are provided for more easily understanding the present disclosure and conducting an experiment on effects of the present disclosure, and the thickness and size of the ceramic substrate 200 or the metal layer 300 applied to the present disclosure are not limited by the embodiments.

**[Table 1]**

| | Angle (°) | Interval (µm) | Depth (µm) (Depth (%)) | Radius of Curvature (µm) of Corner | Cutting Defect Rate (%) | Crack Defect Rate (%) |
|---|---|---|---|---|---|---|
| Embodiment 1 | 73 | 130 | 110 (34) | 35 | 0 | 0 |
| Embodiment 2 | 73 | 130 | 130 (41) | 35 | 0 | 0 |
| Embodiment 3 | 73 | 130 | 170 (53) | 35 | 0 | 0 |
| Embodiment 4 | 73 | 130 | 130 (41) | 20 | 0 | 0 |
| Embodiment 5 | 73 | 130 | 130 (41) | 35 | 0 | 0 |
| Embodiment 6 | 73 | 130 | 130 (41) | 48 | 0 | 0 |
| Embodiment 7 | 73 | 120 | 130 (41) | 35 | 0 | 0 |
| Embodiment 8 | 73 | 140 | 130 (41) | 35 | 0 | 0 |
| Embodiment 9 | 75 | 130 | 130 (41) | 35 | 0 | 0 |
| Embodiment 10 | 77 | 140 | 120 (37) | 35 | 0 | 0 |

**[Table 2]**

| | Angle (°) | Interval (µm) | Depth (µm) (Depth (%)) | Radius of Curvature (µm) of Corner | Cutting Defect Rate (%) | Crack Defect Rate (%) |
|---|---|---|---|---|---|---|
| Comparative Example 1 | 63 | 90 | 130 (41) | 35 | 10 | 80 |
| Comparative Example 2 | 68 | 90 | 130 (41) | 35 | 15 | 30 |
| Comparative Example 3 | 73 | 90 | 130 (41) | 35 | 25 | 0 |
| Comparative Example 4 | 80 | 90 | 130 (41) | 35 | 25 | 0 |
| Comparative Example 5 | 73 | 110 | 130 (41) | 35 | 10 | 0 |
| Comparative Example 6 | 73 | 150 | 130 (41) | 35 | 5 | 0 |
| Comparative Example 7 | 73 | 170 | 130 (41) | 35 | 85 | 0 |
| Comparative Example 8 | 73 | 130 | 80 (25) | 35 | 30 | 0 |
| Comparative Example 9 | 73 | 130 | 190 (59) | 35 | 10 | 10 |
| Comparative Example 10 | 73 | 130 | 130 (41) | 16 | 0 | 20 |
| Comparative Example 11 | 73 | 130 | 130 (41) | 55 | (Laser Machining Defect) | (Laser Machining Defect) |

Referring to FIG. 9, it can be seen that when the cutting recess 410 is formed on the ceramic substrate by using a laser, a crack incidence rate of the ceramic substrate gradually decreases as the angle 431 between the first inclined surface 411 and the second inclined surface 412 increases, and it can be seen that when the angle 431 is 71° or more, a crack defect does not occur any more during ultrasonic welding. It can be seen that as the angle 431 in the cutting recess 410 increases, an external force applied due to vibration of an oscillator generated during ultrasonic welding is not concentrated on the cutting recess 410, stress is distributed, and thus a crack defect is decreased.

As can be seen from the embodiments 1 to 7 and the comparative examples 1 to 7 depending on the interval 433 between the corners 413, a cutting defect and a crack defect do not occur when the interval 433 between the corners 413 ranges from 120 µm to 140 µm, but a cutting defect occurs in the case of the comparative examples 1 to 7 in which the interval 433 is narrow or wide. In particular, in the case of the comparative example 7 in which the interval 433 is 170 µm, a cutting defect rate is significantly increased.

Furthermore, as can be seen from the embodiments 8 and 9 and the comparative examples 8 and 9 depending on the depth 435 of the cutting recess 410, a cutting defect occurs in the case of the comparative example 8 in which the depth 435 of the cutting recess 410 is small, and a crack defect, together with a cutting defect, occurs in the case of the comparative example 9.

At this time, the depth (%) in Tables 1 and 2 represents the ratio of the depth of the cutting recess to the thickness (320 µm) of the ceramic substrate 200.

In the case of the embodiments 10 and 11 and the comparative examples 10 and 11 depending on the radius of curvature of the corner 413 of the cutting recess 410, when the corner 413 has a radius of curvature of 18 µm (comparative example 10), stress is not sufficiently distributed for vibration of an oscillator applied during ultrasonic welding, and therefore a crack defect occurs, and when the corner 413 has a radius of curvature of 53 µm (comparative example 11), laser machining is not performed, and therefore the cutting recess 410 is not formed, or the first and second inclined surfaces 411 and 412 are not correctly formed.

Accordingly, as in the embodiments, when the interval 433 between the corners 413 ranges from 120 µm to 140 µm, the radius of curvature of the corner 413 of the cutting recess 410 is formed in the range of 20 µm to 50 µm. Accordingly, the cutting recess 410 may be formed through laser machining such that the ceramic substrate is easily cut and a cutting defect does not occur. Furthermore, during an ultrasonic welding process of the ceramic substrate, a crack may be minimized by distributing stress of vibration by an oscillator.

In conclusion, it can be seen that a cutting defect and a crack defect are minimized when the angle 431 between the first inclined surface 411 and the second inclined surface 412 is 71 degrees or more, the interval 433 (the laser irradiation interval) between the corners 413 of the cutting recesses 410 ranges from 120 µm to 140 µm, and the depth 435 of the cutting recess 410 ranges from 30% to 54% of the thickness of the ceramic substrate 200.

In particular, it can be seen that a crack defect on the ceramic substrate that occurs during ultrasonic welding is most sensitive to the angle 431 between the first inclined surface 411 and the second inclined surface 412, and as the machining angle 431 increases, stress caused by ultrasonic welding is efficiently alleviated.

As described above, the ceramic circuit substrate according to the embodiment of the present disclosure in which the shape of the cutting recess of the cutting portion is improved may minimize a cutting defect in a cutting process of dividing the ceramic circuit substrate into the separate circuit substrates and may minimize a crack defect when a lead frame is welded by ultrasonic welding.

Accordingly, according to the present disclosure, the ceramic circuit substrate may provide an effect of improving product reliability in manufacturing a power module.

Hereinabove, although the present disclosure has been described with reference to exemplary embodiments and the accompanying drawings, the present disclosure is not limited thereto, but may be variously modified and altered by those skilled in the art to which the present disclosure pertains without departing from the spirit and scope of the present disclosure claimed in the following claims.

## Claims

1. A ceramic circuit substrate comprising:
a ceramic substrate; and
a metal layer configured to form circuit patterns on a surface of the ceramic substrate,
wherein the ceramic substrate includes a cutting portion in which a plurality of cutting recesses provided between the circuit patterns and concavely formed on the ceramic substrate are arranged.

2. The ceramic circuit substrate of claim 1, wherein each of the cutting recesses includes:
a first inclined surface;
a second inclined surface inclined at an angle of 71 degrees or more with respect to the first inclined surface; and
a corner at which the first inclined surface and the second inclined surface meet.

3. The ceramic circuit substrate of claim 2, wherein an interval between the corners of the cutting recesses adjacent to each other ranges from 120 µm to 140 µm.

4. The ceramic circuit substrate of claim 2, wherein the corner has a radius of curvature ranging from 20 µm to 50 µm.

5. The ceramic circuit substrate of claim 1, wherein the cutting recesses are formed to have a depth of 30% to 54% of a thickness of the ceramic substrate.
